# EUROPEAN PATENT APPLICATION

(11) **EP 2 312 629 A1**
(43) Date of publication of application: **20.04.2011**
(21) Application number: 10013707.4
(22) Date of filing: 15.10.2010
(51) Int. Cl.: H01L 23/498, H01L 33/62

(54) **Chip lead frame and photoelectric energy transducing module**

(30) Priority: 16.10.2009 TW 98135059
(71) Applicant: NeoBulb Technologies, Inc., Bandar Seri Begawan (BN)
(72) Inventor: Chen, Jen-Shyan, Hsinchu City Taiwan 30046 (CN); Lin, Chung-Jen, Taipei Taiwan (CN); Peng, Yun-Lin, Zhudong Township Hsinchu County 311 Taiwan (CN); Wen, Wei-Yeh, Jhbei City Hsinchu County 302 Taiwan (CN)
(74) Representative: Goddar, Heinz J.

(57) **Abstract**

The invention discloses a chip lead frame and a photoelectric energy transducing module. The chip lead frame includes an insulator and a plurality of conductors. The insulator includes a first surface, a second surface, a first recess structure formed on the first surface, a through hole passing through the second surface and the first recess structure, and a venting structure. The first recess structure forms an accommodating space. The venting structure communicates with the accommodating space so that when a substrate is being bound to the first recess structure, the air in the accommodating space pressed by the substrate could flow through the venting structure out of the insulator without remaining between the substrate and the first recess structure. A photoelectric energy transducing semiconductor structure could be disposed on the substrate and electrically connected to the conductors, so as to form the photoelectric energy transducing module of the invention.

## Description

### BACKGROUND OF THE INVENTION

### 1. Field of the invention

The present invention relates to a chip lead frame and a photoelectric energy transducing module, which are particularly able to be attached to a substrate firmly.

### 2. Description of the prior art

With the increasing popularity on applications of semiconductor devices, a variety of packaging techniques have been developed. In one of these techniques, a chip lead frame including a substrate is manufactured first; then, the chip (or called a die) is fixed onto the substrate. Due to the miniaturization trend in electronic products, there is relatively small space to accommodate electronic products. The size of the chip lead frame is limited, making the attachment area between the aforementioned substrate and the chip lead frame is also quite limited. Thus, strong attachments of electronic products have become the primary issues for solutions.

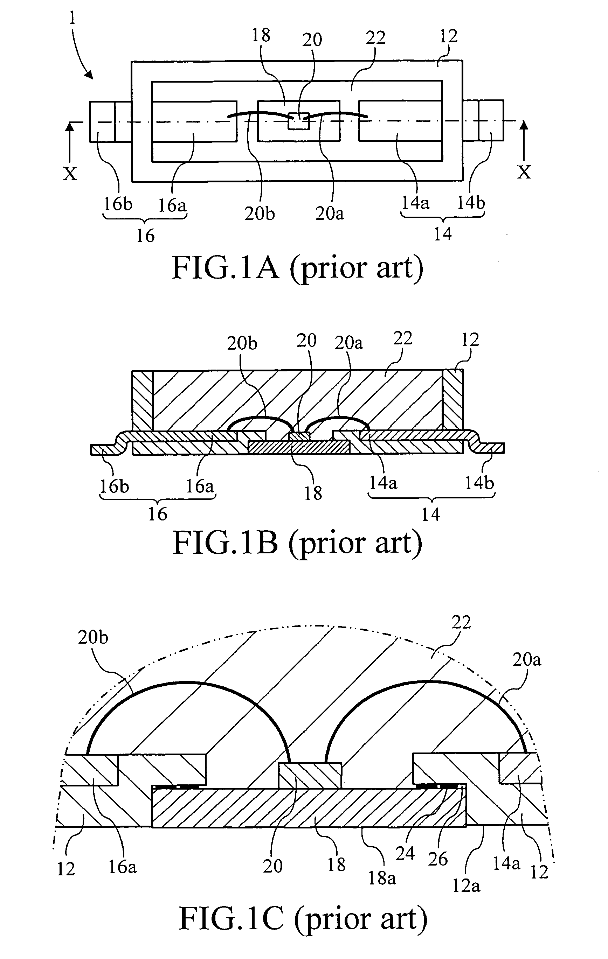

Please refer to FIG.1A, FIG.1B and FIG.1C. FIG.1A illustrates an upper view of a light-emitting diode 1 according to an embodiment of the prior art. FIG.1B illustrates a cross section view of the light-emitting diode 1 in FIG.1A with respect to the X-X line. FIG.1C illustrates a partial enlargement view of the central portion in FIG.1B. The light-emitting diode 1 includes an insulated base 12, two connection conductors (14, 16), a substrate 18, a light-emitting chip 20, and sealing compound 22. In manufacture, the connection conductors (14, 16) and the insulated base 12 are formed at one time by the insertion molding. The insertion molding component has a recess structure and a holder which is opposite and communicates with the recess structure. The inside electrodes (14a, 16a) of the connection conductors (14, 16) are exposed inside the recess structure, while the outside electrodes (14b, 16b) are exposed outside the insulated base 12. Next, the substrate 18 is disposed inside the holder and exposed inside the recess structure and outside the bottom surface 12a of the insulated base 12. Subsequently, the light-emitting chip 20 is fixed onto the substrate 18 and electrically connected to the inside electrodes (14a, 16a) through the conducting wires (20a, 20b) in wire-bonding. Finally, the sealing compound 22 is used to seal the recess structure.

In principle, the fixing of the substrate 18 is determined by the adhesion of the substrate 18 to the insulated base 12 and the sealing compound 22. If the adhesion of the substrate 18 to the insulated base 12 or the sealing compound 22 is not good, the substrate 18 falls off from the light-emitting diode easily although the substrate 18, the connection conductors (14, 16) and the insulated base 12 are formed at one time by the insertion molding. Hence, the glue 24 is often used to attach the substrate 18 and the insulated base 12. Because the volume of the accommodating space of the holder is similar to that of the substrate 18, the coating of the glue 24 is often uneasy to attach the substrate 18 to the insulated base 12 ineffectively and cause the gap 26 at the attachment area, making the substrate 18 still fall off from the light-emitting diode 1 easily.

There is another problem as follows. Because the volume of the accommodating space of the holder is similar to that of the substrate 18, it is easy for the bottom surface 18a of the substrate 18 to protrude relative to the bottom surface 12a of the insulated base 12 if the coating location and amount of the glue 24 are not controlled well. This condition becomes more severe when the abovementioned gap 26 exists.

Accordingly, the substrate 18 is not able to be fixed on the insulated base 12 by the prior art. It is even possible for the substrate 18 to fall off to cause inconvenience for the follow-up process after the product (the light-emitting diode 1) leaves the factory. In addition, the possible protrusion of the bottom surface 18a of the substrate 18 will affect the surface mounting process.

### SUMMARY OF THE INVENTION

One scope of the invention is to provide a chip lead frame having a recess structure and a venting structure communicating with the recess structure. When a substrate is attached to the recess structure, air pressed by the substrate in the recess structure could flow out through the venting structure.

Another scope of the invention is to provide a photoelectric energy transducing module having the above chip lead frame.

The chip lead frame of the invention includes an insulator and a plurality of conductors. The insulator includes a first surface, a second surface, a first recess structure formed on the first surface, a through hole passing through the second surface and the first recess structure, and a venting structure. The first recess structure forms an accommodating space, and the venting structure communicates with the accommodating space. Each conductor connects the insulator and includes a first connection portion and a second connection portion, wherein the first connection portion and the second connection portion is exposed outside the insulator.

When a substrate is connected to the first recess structure with glue, the accommodating space is substantially filled with the substrate. One portion of air in the first recess structure is capable of flowing out of the insulator through the through hole directly, while the other portion of air, especially close to the glue, or squeezed between the substrate and the first recess structure, is capable of flowing out of the insulator through the venting structure.

Obviously in the prior art, air stagnated between the substrate and the insulator by the glue can escape effectively through the venting structure of the present invention, leading to increases in the attachment area and the attachment strength. Besides, the substrate will not protrude from the bottom surface of the insulator to cause inconvenience in the follow-up use or manufacturing process.

The photoelectric energy transducing module of the invention includes the chip lead frame attached with the substrate and a photoelectric energy transducing semiconductor structure disposed on the substrate, exposed outside the through hole and electrically connected to the second connection portions of the conductors. The photoelectric energy transducing semiconductor structure is a solar cell semiconductor structure, a light-emitting diode semiconductor structure or the combination thereof.

As mentioned above, the substrate can be attached to a heat-dissipating module well for it does not skew or protrude from the insulator. Thus, heat generated in the operation of the photoelectric energy transducing semiconductor structure can be conducted to the heat-dissipating module through the substrate quickly to extend the life of the photoelectric energy transducing module.

The advantage and spirit of the invention may be understood by the following recitations together with the appended drawings.

### BRIEF DESCRIPTION OF THE APPENDED DRAWINGS

FIG.1A illustrates an upper view of a light-emitting diode according to an embodiment of the prior art.
FIG.1B illustrates a cross section view of the light-emitting diode in FIG.1A with respect to the X-X line.
FIG. 1C illustrates a partial enlargement view of the central portion in FIG.1B.
FIG.2A illustrates a three-dimensional diagram of the chip lead frame according to an embodiment of the invention.
FIG.2B illustrates a three-dimensional diagram of the chip lead frame in FIG.2A in another view.
FIG.3A illustrates a vertical view of the chip lead frame.
FIG.3B illustrates an enlarged cross section view of the chip lead frame with respect to the Y-Y line.
FIG.4 illustrates a cross section view of the photoelectric energy transducing module according to an embodiment of the invention.
FIG.5 illustrates a partial cross section view of the substrate, the first recess structure, and the venting structure.
FIG.6A and FIG.6B illustrate schematic diagrams of two different venting structures.
FIG.7 illustrates a cross section view of the photoelectric energy transducing module according to an embodiment of the invention.
FIG.8 illustrates another cross section view of the photoelectric energy transducing module according to an embodiment of the invention.
FIG.9 illustrates another cross section view of the photoelectric energy transducing module according to an embodiment of the invention.

### DETAILED DESCRIPTION OF THE INVENTION

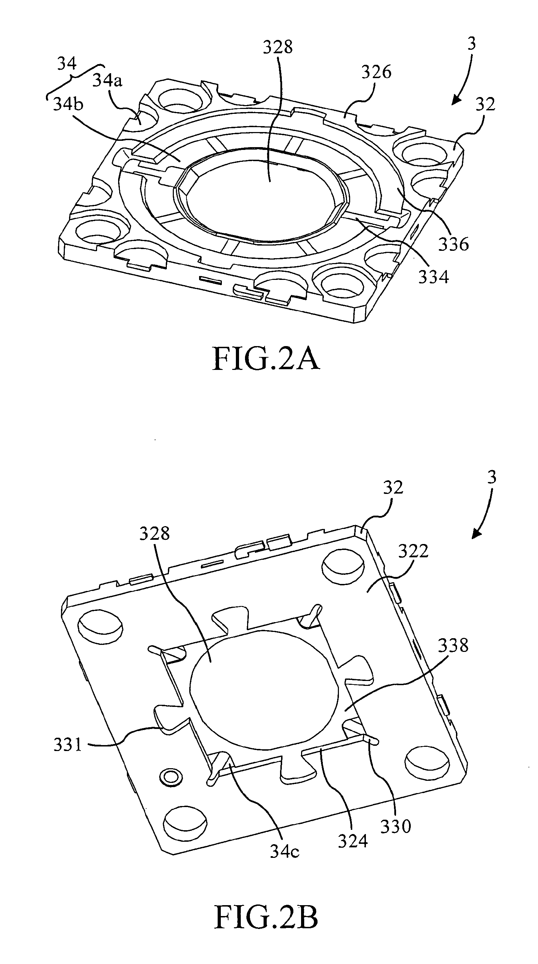

Please refer to FIG.2A and FIG.2B which illustrate two three-dimensional diagrams in different views of the chip lead frame 3 according to an embodiment of the invention. The chip lead frame 3 includes an insulator 32 surrounded by a plurality of conductors 34 (only one is labeled). Each conductor 34 includes a first connection portion 34a and a second connection portion 34b. The second connection portion 34b is used to be connected to the chip electrode, while the first connection portion 34a is an electrode for external connection. The insulator 32 includes a first recess structure 324 formed on a first surface 322 and a through hole 328 passing through a second surface 326 and the first recess structure 324. The first surface 322 is opposite to the second surface 326. The first recess structure 324 forms an accommodating space (not labeled) for receiving a substrate (see the explanation in the following embodiment).

The insulator 32 also includes four venting structures 330 (only one is labeled) which communicate with the accommodating space so that air in the accommodating space is capable of flowing out of the insulator 32 through the venting structures 330. The insulator 32 further includes four operation recess structures 331 (only one is labeled) divided into two oppositely disposed pairs and connected to the first recess structure 324. These operation recess structures 331 have operation space for automatic equipment or a user utilizing a tool, e.g. a clamp, to place the substrate into the first recess structure 324. As shown in FIG.2B, when the substrate is disposed inside the first recess structure 324, most of the air in the first recess structure 324 (or regarded as the air in the accommodating space is capable of flowing out of the insulator 32 and toward the second surface 326 through the through hole 328 directly, while certain portion of the air, especially at the four corners of the first recess structure 324, is capable of flowing out through the venting structure 330.

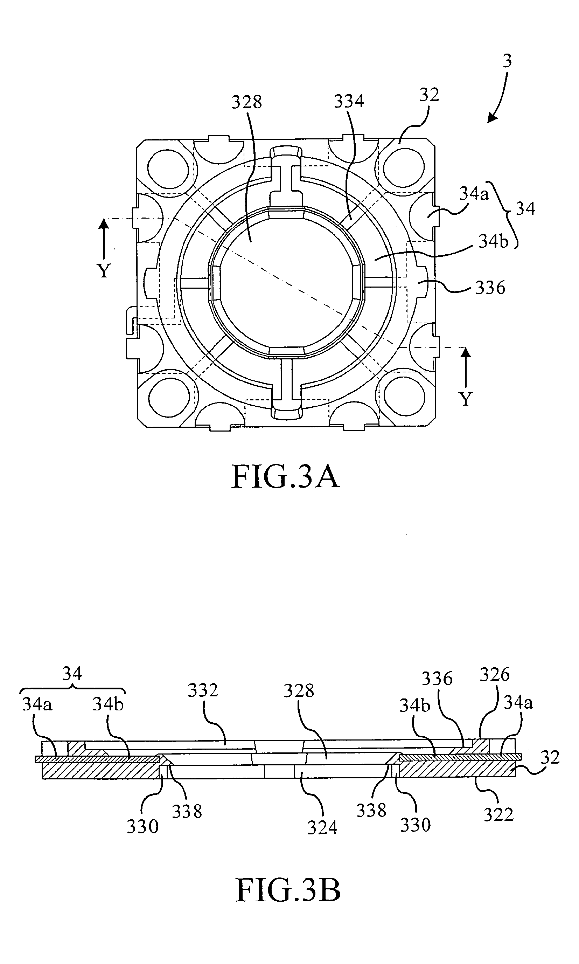

Please refer to FIG.3A which illustrates a vertical view of the chip lead frame 3 and FIG.3B which illustrates an enlarged cross section view of the chip lead frame 3 with respect to the Y-Y line. In FIG.3A, the portions of the conductors 34 covered by the insulator 32 are marked by the dotted line, so it is clear to see the arrangement of the conductors 34 within the chip lead frame 3. In this embodiment, the second connection portions 34b of the conductors 34 are disposed to surround the through hole 328 substantially. The quantities and locations of the conductors 34 are not restricted to the embodiments in the present invention, but dependent on the demands of practical products. Figure.3B shows the structure of the chip lead frame 3 more clearly.

As shown in Figure.3B, the insulator 32 also includes a second recess structure 332 formed on the second surface 326, and the through hole 328 passes through the first recess structure 324 and the second recess structure 332. The first recess structure 324 includes a first connection surface 338 for the glue to attach the substrate into the first recess structure 324. The first connection surface 338 may have a rough surface which is helpful for the above-mentioned attachment. Besides, in this embodiment, the first connection surface 338 is substantially, but not limited to, parallel to the first surface 322.

In addition, the second recess structure 332 includes a second connection surface 334, and the second connection portion 34b is exposed outside the second connection surface 334. Generally, after the substrate is attached and the chip is fixed and bonded, the second recess structure 332 is filled with sealing compounds to protect the chip and its connecting wires; thus, the second connection surface 334 may also have a rough surface helpful for the attachment of the sealing compounds. Additionally, the insulator 32 includes a holding plane 336 for holding an optical adjustment device, e.g. a lens. Certainly, the above-mentioned sealing compound may have a lens contour directly (e.g. a protrusion from the insulator 32) to have the optical adjustment function.

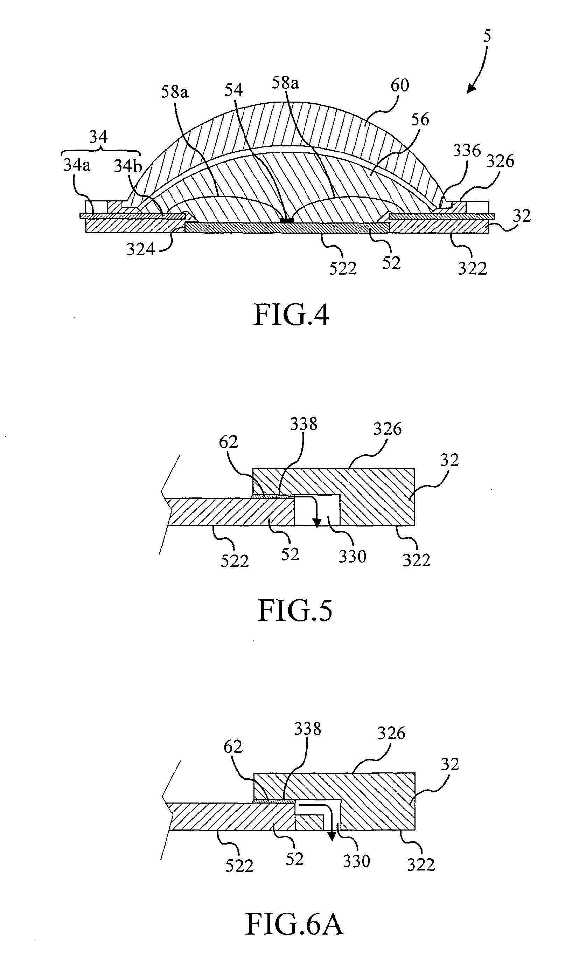

Please refer to FIG.4 which illustrates a cross section view of the photoelectric energy transducing module 5 according to an embodiment of the invention. The photoelectric energy transducing module 5 mainly include the previous chip lead frame 3 together with the substrate 52, the photoelectric energy transducing semiconductor structure 54, and material pervious to light (the sealing compound 56). The primary structure of the photoelectric energy transducing module 5 is substantially similar to that of the chip lead frame 3, so FIG.4 having the same profile section as FIG.3B is used for illustration directly.

Please refer to FIG.3B and FIG.4. The substrate 52 of the photoelectric energy transducing module 5 is disposed inside the first recess structure 324, and the substrate 52 is substantially filled with the accommodating space of the first recess structure 324. The photoelectric energy transducing semiconductor structure 54 (e.g. an LED die) is disposed on the substrate 52 and electrically bonded to the second connection portions 34b of the conductors 34 by the metal wires 58a, 58b. The sealing compound 56 seals the photoelectric energy transducing semiconductor structure 54 and the metal wires 58a, 58b. To improve the light collecting effect, the sealing compound 56 may have a convex contour and further have an optical adjustment device 60 thereon. In principle, if the optical adjustment device 60 connects the holding plane 336 well to be able to protect the photoelectric energy transducing semiconductor structure 54 and the metal wires 58a, 58b, then the sealing compound 56 is removable. In another embodiment, the optical adjustment device 60 (e.g. an optical lens) may be fixed onto the chip lead frame 3 by the sealing compound 56, and there is no gap between the optical adjustment device 60 and the sealing compound 56.

Please refer to FIG.5 which illustrates a partial cross section view of the substrate 52, the first recess structure 324, and the venting structure 330. It should be noted that the dimension of each component in Fig. is not corresponding to that in FIG.4 because FIG.5 is merely for illustration of the partial structural properties of some components in the photoelectric energy transducing module 5. As shown in FIG.5, the substrate 52 is attached to the first connection surface 338 of the first recess structure 324 by the glue 62 which is fully filled between the substrate 52 and the first recess structure 324 to avoid the gap 26 as shown in FIG. 1C. It is achieved because during the attachment process, air originally in the first recess structure 324 is able to flow through the venting structure 330 (please refer to the 3-D structure in FIG.2B as well) out of the insulator 32 under pressure from the substrate 52; the flow path is marked as the bold solid line with an arrow in FIG.5. Therefore, the substrate 52 does not skew or protrude from the bottom surface of the insulator 32, i.e. the first surface 322 in this embodiment, for it is controllably disposed inside the first recess structure 324.

It is understood from the above explanations that the venting structure 330 is required to have a ventilation structure; in a simply way, the venting structure 330 may have, but not limited to, a channel structure to connect the accommodating space of the first recess structure 324 and the outside of the insulator 32. For example, it also achieves the purpose of the venting structure of the present invention to use the structure with communicable holes. Obviously in this embodiment, the venting structure 330 is composed of a recess which protrudes from the first recess structure 324 to form on the first surface 322; this is usually, but not limited to, the easier way to form the necessary channel of the venting structure 330.

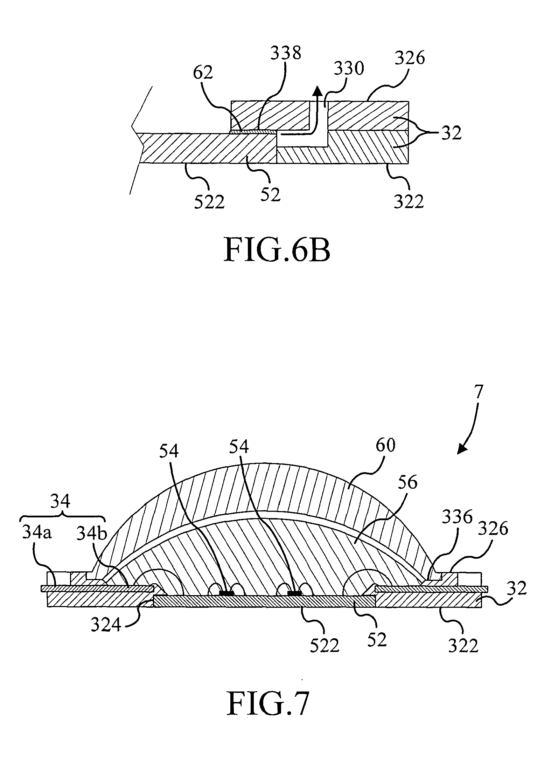

Please refer to FIG.6A and FIG.6B which illustrate schematic diagrams of two different venting structures 330. The venting structure 330 in FIG.6A is a through hole passing through the first recess structure 324 and the first surface 322; surely, the through hole can also lead to the second surface 326 as shown in FIG.6B. It is additionally mentioned that the insulator 32 in FIG.5 and FIG.6A may be, but not limited to, made in one piece. As shown in FIG.6B, the insulator 32 is composed of the upper and lower parts, and this design is helpful for the formations of various channels, i.e. the venting structure 330.

Please return to FIG.2B. During the attachment of the substrate 52 into the first recess structure 324, air at the corners of the first recess structure 324 is difficult to flow out since being obstructed by the walls of the corners; however, the venting structure 330 formed at the corners is very helpful for the air to escape. Of course, the quantities and locations of the venting structures are not restricted to the embodiments in the present invention, but dependent on the structure of the first recess structure of the practical product.

Please return to FIG.2B and FIG.3A. It is additionally explained that each conductor 34 includes a third connection portion 34c exposed outside the accommodating space of the first recess structure 324, making the substrate 52 able to attach the third connection portion 34c by the glue 62. The metallic third connection portion 34c is helpful for fixing the substrate 52. Besides, the third connection portion 34c in FIG.2B is a little bit lower than the first connection surface 338. When the substrate 52 is attached to the first connection surface 338, accommodating space is formed between the substrate 52 and the third connection portion 34c. Thus, although the third connection portion 34c is not used to strengthen the attachment of the substrate 52, the accommodating space is used for the pressed air between the first connection surface 338 and the substrate 52 to escape.

Please refer to FIG.7 which illustrates a cross section view of the photoelectric energy transducing module 7 according to an embodiment of the invention. The photoelectric energy transducing module 7 is different from the photoelectric energy transducing module 5 as follows. The photoelectric energy transducing semiconductor structure 54 of the photoelectric energy transducing module 7 is electrically connected to the substrate 52 first and the second connection portions 34b of the conductors 34 by use of the substrate 52, so as to achieve the electrical connection of the photoelectric energy transducing semiconductor structure 54 and the conductors 34. In this way, more photoelectric energy transducing semiconductor structures 54 can be disposed on the substrate 52 easily. Of course, there may be suitable layouts formed on the substrate 52, but related descriptions are not stated herein.

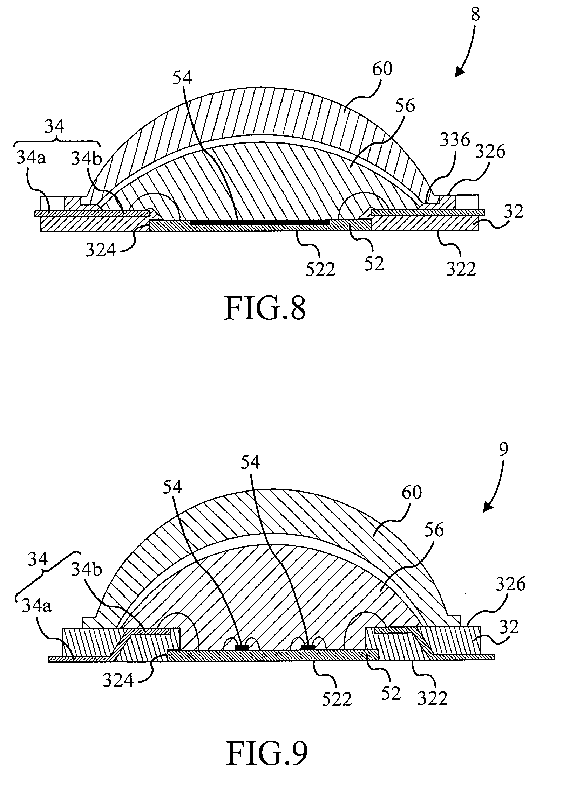

Please refer to FIG.8 which illustrates another cross section view of the photoelectric energy transducing module 8 according to an embodiment of the invention. Being different from the photoelectric energy transducing module 5, the photoelectric energy transducing semiconductor structure 54 of the photoelectric energy transducing module 8 is formed on the substrate 52 directly instead of being an independent die. For example, if the substrate 52 is made of semiconductor materials, the photoelectric energy transducing semiconductor structure 54 will be formed on the substrate 52 more easily.

In the above embodiments, the photoelectric energy transducing semiconductor structure 54 may be a solar cell semiconductor structure, a light-emitting diode semiconductor structure or the combination thereof. Thus, the photoelectric energy transducing module containing the photoelectric energy transducing semiconductor structure can serve as a solar cell; the photoelectric energy transducing module containing the light-emitting diode semiconductor structure can serve as an illumination apparatus. The optical adjustment device 60, right toward the photoelectric energy transducing semiconductor structure 54 and disposed on the insulator 32, is for adjusting light emitted from or being entering the photoelectric energy transducing semiconductor structure 54, so as to improve the conversion efficiency of the photoelectric energy transducing semiconductor structure 54.

It is additionally explained that the second recess structure 332 may not be included in the present invention although it appears in the above embodiments. Please refer to FIG.9 which illustrates another cross section view of the photoelectric energy transducing module 9 according to an embodiment of the invention. Being different from the photoelectric energy transducing module 5, the photoelectric energy transducing module 9 does not have the second recess structure 332, and the second connection portions 34b of the conductors 34 are exposed outside the second surface 326 directly. Thus, the second surface 326 is a rough surface helpful to attach the sealing compound 56. In addition, the first connection portions 34a of the conductors 34 are exposed outside the bottom surface of the insulator 32, i.e. the first surface 322, directly, so as to cause the photoelectric energy transducing module 9 a surface mounting device.

In another embodiment, a heat-conducting device (not shown in FIG.8 or FIG.9) may be attached to the lower surface of the substrate 52 of the photoelectric energy transducing semiconductor structure 54. The heat-conducting device may be the general heat-dissipating fins or a heat pipe having a flat end which attaches the lower surface 522 of the substrate 52 tightly by using e.g. the thermal conductive glue or thermal phase change materials, so as to increase the heat-dissipating efficiency of the photoelectric energy transducing semiconductor structure 54.

With the example and explanations above, the features and spirits of the invention will be hopefully well described. Those skilled in the art will readily observe that numerous modifications and alterations of the device may be made while retaining the teaching of the invention. Accordingly, the above disclosure should be construed as limited only by the metes and bounds of the appended claims.

## Claims

1. A chip lead frame comprising:
an insulator comprising a first surface, a second surface, a first recess
structure formed on the first surface, a through hole passing through the second surface and the first recess structure, and a venting structure, the first recess structure forming an accommodating space, the venting structure communicating with the accommodating space so that air in the accommodating space is capable of flowing out of the insulator through the venting structure; and
a plurality of conductors, wherein each conductor connects the insulator and
comprises a first connection portion and a second connection portion, the first connection portion and the second connection portion being exposed outside the insulator.

2. The chip lead frame of claim 1, wherein the venting structure comprises a channel communicating with the accommodating space and the outside of the insulator.

3. The chip lead frame of claim 1, wherein the venting structure comprises a recess which protrudes from the first recess structure to form on the first surface.

4. The chip lead frame of claim 1, wherein the first recess structure comprises a corner which the venting structure connects to communicate with the accommodating space.

5. The chip lead frame of claim 1, wherein the first surface is opposite to the second surface, the second connection portion of each conductor is exposed outside the second surface.

6. The chip lead frame of claim 5, wherein the second connection portions of the conductors surround the through hole substantially.

7. The chip lead frame of claim 1, wherein one of the conductors comprises a third connection portion exposed outside the accommodating space.

8. The chip lead frame of claim 1, wherein the first recess structure comprises a first connection surface comprising a rough surface.

9. The chip lead frame of claim 8, wherein the first connection surface is substantially parallel to the first surface.

10. The chip lead frame of claim 1, further comprising a substrate connected to the first recess structure with glue, the accommodating space is substantially filled with the substrate.

11. The chip lead frame of claim 10, wherein the insulator comprises two operation recess structures formed on the first surface and connected to the first recess structure symmetrically, each operation recess structure has an operation space communicating with the accommodating space.

12. The chip lead frame of claim 1, wherein the second surface has a rough surface.

13. The chip lead frame of claim 1, wherein the insulator comprises a second recess structure formed on the second surface, the through hole passes through the first recess structure and the second recess structure.

14. The chip lead frame of claim 13, wherein the second recess structure comprises a second connection surface comprising a rough surface.

15. The chip lead frame of claim 14, wherein the second connection portions of the conductors are exposed outside the second connection surface.

16. A photoelectric energy transducing module comprising:
an insulator comprising a first surface, a second surface, a first recess
structure formed on the first surface, a through hole passing through the second surface and the first recess structure, and a venting structure, the first recess structure forming an accommodating space, the venting structure communicating with the accommodating space so that air in the accommodating space is capable of flowing out of the insulator through the venting structure;
a plurality of conductors, wherein each conductor connects the insulator and
comprises a first connection portion and a second connection portion, the first connection portion and the second connection portion being exposed outside the insulator;
a substrate connected to the first recess structure with glue, the
accommodating space being substantially filled with the substrate; and
a photoelectric energy transducing semiconductor structure disposed on the
substrate, exposed outside the through hole, and electrically connected to the second connection portions of the conductors.

17. The module of claim 16, wherein the venting structure comprises a channel communicating with the accommodating space and the outside of the insulator.

18. The module of claim 16, wherein the venting structure comprises a recess which protrudes from the first recess structure to form on the first surface.

19. The module of claim 16, wherein the first recess structure comprises a corner which the venting structure connects to communicate with the accommodating
space.

20. The module of claim 16, wherein the first surface is opposite to the second surface, the second connection portion of each conductor is exposed outside the second surface.

21. The module of claim 16, wherein one of the conductors comprises a third connection portion exposed outside the accommodating space, and the substrate is connected to the third connection portion with the glue.

22. The module of claim 16, further comprising a heat-conducting device connected to a lower surface of the substrate.

23. The module of claim 22, wherein the heat-conducting device is a heat pipe having a flat end which joins the lower surface of the substrate.

24. The module of claim 16, wherein the insulator comprises a second recess structure formed on the second surface, the through hole passes through the first recess structure and the second recess structure.

25. The module of claim 24, wherein the second recess structure comprises a second connection surface comprising a rough surface, the photoelectric energy transducing module comprises a package material which is pervious to light and covers the second connection surface and the photoelectric energy transducing semiconductor structure.

26. The module of claim 25, wherein the second connection portions of the conductors are exposed outside the second connection surface.

27. The module of claim 16, wherein the first recess structure comprises a corner which the venting structure connects to communicate with the accommodating space.

28. The module of claim 16, further comprising an optical adjustment device, right toward the photoelectric energy transducing semiconductor structure and disposed on the insulator, for adjusting light emitted from or being entering the photoelectric energy transducing semiconductor structure.

29. The module of claim 16, wherein the photoelectric energy transducing semiconductor structure is a solar cell semiconductor structure, a light-emitting diode semiconductor structure or the combination thereof.

30. The module of claim 29, wherein the photoelectric energy transducing semiconductor structure is formed on the substrate.
